# EUROPÄISCHE PATENTSCHRIFT

(11) **EP 2 356 000 B1**
(45) Veröffentlichungstag und Bekanntmachung des Hinweises auf die Patenterteilung: **02.01.2013**
(21) Anmeldenummer: 09748758.1
(22) Anmeldetag: 30.10.2009
(51) Int. Cl.: B60S 1/08

(54) **STÖRKOMPENSIERTER SENSOR**
INTERFERENCE-COMPENSATED SENSOR
DÉTECTEUR À COMPENSATION DE PERTURBATION

(30) Priorität: 20.11.2008 EP 08169519
(43) Veröffentlichungstag der Anmeldung: 17.08.2011
(73) Patentinhaber: ELMOS Semiconductor AG, 44227 Dortmund (DE); Mechaless Systems GmbH, 76131 Karlsruhe (DE)
(72) Erfinder: MELCHER, Rolf, 76227 Karlsruhe (DE); MÜSCH, Erhard, 59368 Werne (DE); SCHWENINGER, Erhard, 76149 Karlsruhe (DE); ZAWACKI, Roberto, 76703 Kraichtal (DE)
(74) Vertreter: von Kreisler Selting Werner
(86) Internationale Anmeldenummer: PCT/EP2009/064389
(87) Internationale Veröffentlichungsnummer: WO 2010/057764

(56) Entgegenhaltungen:
- DE-A1-102007 009 099
- US-A- 5 726 547

## Beschreibung

### Gegenstand der Erfindung

Die Erfindung betrifft einen störkompensierten Sensor zur berührungslosen Erfassung eines in einem Erfassungsbereich befindlichen Objekts, bei dem es sich beispielsweise um einen auf eine insbesondere Windschutzscheibe auftreffenden Regentropfen handelt. Insbesondere betrifft die Erfindung also einen störkompensierten Regensensor.

### Hintergrund der Erfindung

Hinlänglich bekannt sind Sensoren, die ihr (eigentliches) Ausgangssignal Im Rahmen eines Kompensationsverfahrens in einem Regelprozess bilden.

Beispielsweise wird in EP-B-0 706 648 ein Verfahren beschrieben, welches auch unter dem Namen "Halios" bekannt geworden ist und auf optische, kapazitive und induktive Sensorik angewendet werden kann.

Ferner ist aus DE-A-10 2007 009 099 eine Vorrichtung bekannt, welche die Befeuchtung einer Glasscheibe eines Kraftfahrzeuges berührungslos erkennen kann.

### Halios-Realisierung mit RC-Tiefpässen

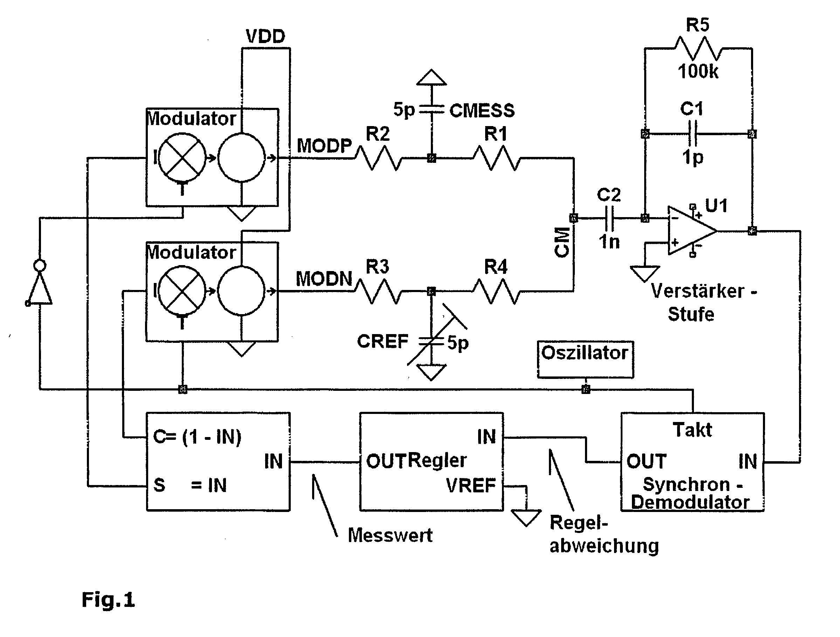

Die Arbeitsweise eines kapazitiven Sensors basierend auf diesem Messverfahren veranschaulicht Fig. 1. Zwei Gegentaktsignale, die in der Amplitude modulierbar sind, werden an den Knotenpunkten MODP und MODN in eine Messbrücke, bestehend aus zwei Tiefpässen, eingespeist. Das verstärkte Signal wird vom Synchron-Demodulator hinsichtlich des Restsignals bewertet, so dass der Regler dieses über eine Amplitudenmodulation minimieren kann. Sind beide Brückenzweige identisch, so löscht sich das Signal am Knoten CM aus.

Gilt diese Auslöschung zu jedem Zeitpunkt, so spricht man von einem Nullsignal.

Abhängig vom physikalischen Messprinzip und vom Messverfahren im Einzelnen wird das Nullsignal besser oder schlechter realisiert. So wird z.B. im oben erwähnten, ursprünglichen, d.h. optischen Halios-Verfahren ein sehr gutes (echtes) Nullsignal erreicht. Die Messimpulse in allen Verkörperungen (Sende-Strom, gesendetes und empfangenes Licht, Photostrom in der Photodiode, Spannung am Verstärker) sind weitestgehend formtreu, nämlich rechteckförmig.

Die Halbbrücke in Fig. 1 ermöglicht prinzipiell die Implementierung der Halios-Methode auf kapazitiver Basis. Allerdings ist das am Verstärkerausgang anliegende Signal im Allgemeinen kein echtes Nullsignal mehr. Eine vollständige Auslöschung erfolgt lediglich im abgeglichenen Zustand der Messbrücke. Ist die Brücke verstimmt, sind also C_{MESS} und C_{REF} unterschiedlich, so ist der Regler lediglich in der Lage, durch Veränderung der Amplituden die Messschleife für die Abtastzeitpunkte auszuregeln.

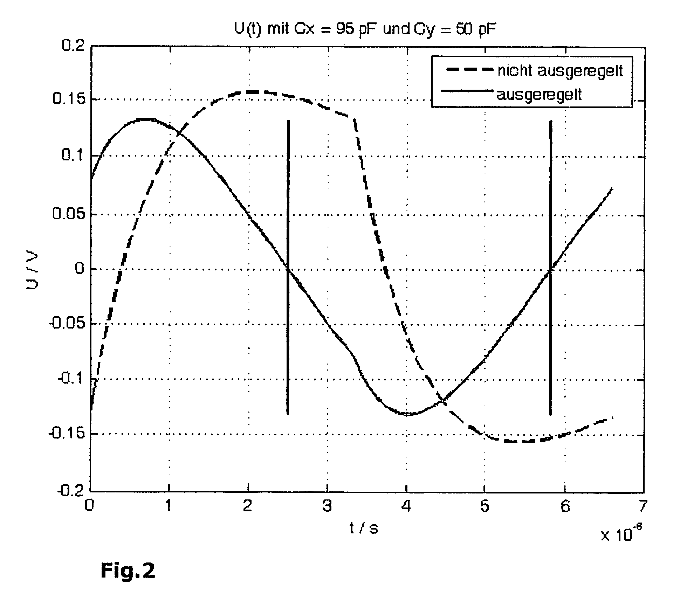

Es entsteht der in Fig. 2 gezeigte Kurvenverlauf am Verstärkerausgang. Das deutlich ausgeprägte "Restsignal" begrenzt die (lineare) Verstärkung dieses Signals deutlich und damit auch die Empfindlichkeit des Sensors.

### Halios-Realisierung mit Längskapazitäten und Ladungsverstärker

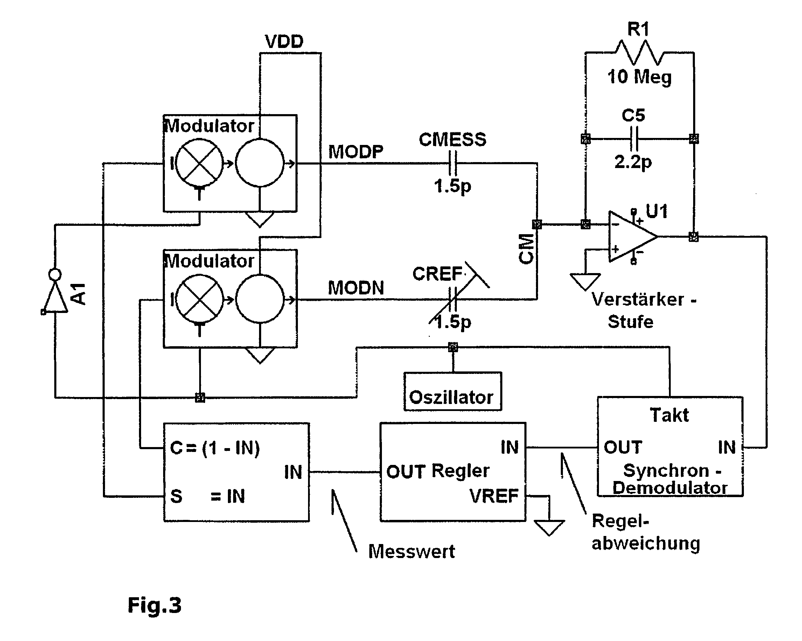

Eine bessere Signalformtreue lässt sich erreichen, indem die Mess- und die Referenz-Kapazitäten nicht nach Masse geschaltet, sondern "längs" eingefügt werden. Wird der Verstärker im Wesentlichen kapazitiv rückgekoppelt, so entsteht der in Fig. 3) gezeigte Ladungsverstärker.

Eine Anregung der Halbbrücke mit Rechtecksignalen ergibt am Verstärkerausgang wieder Rechtecksignale. Der Regler kann das Differenzsignal zu einem echten Nullsignal ausregeln. Die Verstärkung der Verstärkerstufe kann hoch gewählt werden, wodurch der Sensor sehr empfindlich werden kann. Für die praktische Realisierung ist auch die Tatsache vorteilhaft, dass die parasitäre Kapazität des CM-Knotens gegen Masse keine Rolle mehr spielt.

### Verbesserung der EMV

Das Messprinzip kapazitiver Sensorik beruht auf der Beeinflussung der Messkapazitäten bzw. der Beeinflussung der elektrischen Felder in diesen Kapazitäten durch das Messobjekt. Nicht zuletzt ist diese Sensorik prinzipiell empfänglich gegenüber elektromagnetischer Einstrahlung von außen.

Mit einer Erhöhung der Empfindlichkeit der eigentlichen Sensorflächen (z.B. durch Vergrößerung dieser Flächen) steigt auch im Allgemeinen die Empfindlichkeit gegenüber Störungen von außen in gleichem Maße. Dass dieser Nachteil ausgeschaltet oder wesentlich abgeschwächt werden muss, ist für den praktischen Einsatz essentiell.

### Zusammenfassung der Erfindung

Die Erfindung schlägt einen störkompensierten Sensor zur berührungslosen Erfassung eines in einem Erfassungsbereich befindlichen Objekts, insbesondere Regensensor, vor, der versehen ist mit den Merkmalen des Anspruchs 1. Gegenüber dem Stand der Technik hat der erfindungsgemäße Sensor den Vorteil einer hohen Immunität gegen elektromagnetische Störungen (EM-Störungen). Dieser Sensor wird nachfolgend anhand eines kapazitiven Sensorkonzepts erläutert, wie es sich insbesondere für einen kapazitiven Regensensor für z.B. ein Fahrzeug eignet. Grundsätzlich kann der Sensor kapazitiv, induktiv, optisch oder resistiv arbeiten. Der Grundgedanke der Erfindung besteht darin, zwei geometrisch und/oder elektrisch im wesentlichen identische Sensorelemente (nämlich ein Mess- und ein Referenzsensorelement) bzw. Messkanäle vorzusehen, die Fernfeldstörungen im wesentlichen im gleichen Maße ausgesetzt sind, um die durch Fernfeldstörungen erzeugten Störsignale in einem nachgeschalteten Hauptdifferenzbildner zu eliminieren. Sofern die beiden Sensorelemente und/oder Messkanäle eine bekannte Ungleichheit (auch Asymmetrie genannt) aufweisen, kann diese durch eine (ggf. einstellbare) Gewichtung im Hauptdifferenzbildner ausgeglichen werden, was insbesondere im Hinblick auf eine hohe Unterdrückung von elektromagnetischem Rauschen erfolgt.

Wenn im Rahmen der Beschreibung der Erfindung davon die Rede ist, dass das Signal am Ausgang des Hauptdifferenzbildners zu Null regelbar ist, bedeutet dies, dass dieses Signal zumindest zu einem (beliebigen) Zeitpunkt der Regelung zu Null regelbar ist. Damit sind also die Fälle abgedeckt, bei denen das Signal über die gesamte Taktperiode zu Null geregelt wird oder das Signal während eines Teilabschnitts der Taktperiode zu Null geregelt oder aber zumindest zu einem Zeitpunkt zu Null geregelt ist. Mit "Differenzbildung" ist sowohl die Differenz von Spannungspegeln als auch die Differenz von Strompegeln gemeint. Es handelt sich also um die Differenzbildung von allgemeinen Signalpegeln.

In weiterer vorteilhafter Ausgestaltung der Erfindung können beide Messkanäle zeitgleich oder zeitlich alternierend oder aber jeder Messkanal intermittierend und sein Mess- sowie sein Referenzzweig im Gegentaktbetrieb ansteuerbar sein. Die Null-Regelungsansteuerung beider Messkanäle bzw. der Mess- und Referenzzweige beider Messkanäle kann amplitudenmoduliert erfolgen.

In der einfachsten Ausführungsform kann jeder der ersten und zweiten Differenzbildner als Verbindungsknoten der Ausgänge der Mess- und Referenzzweige des betreffenden Messkanals ausgebildet sein. Hierbei ist es ferner von Vorteil, wenn jeder der ersten und zweiten Differenzbildner und/oder der weiteren Differenzbildner einen Signalverstärker aufweist.

In weiterer zweckmäßiger Ausgestaltung der Erfindung kann vorgesehen sein, dass mit Hilfe des Reglersignals die Ansteuereinheiten der Mess- und Referenzzweige beider Messkanäle ansteuerbar sind. Alternativ können die Referenzkanäle verstellbare Referenzelemente aufweisen, die mit Hilfe des Reglersignals veränderbar sind.

Die Erfindung wird nachfolgend anhand mehrerer Ausführungsbeispiele sowie unter Bezugnahme auf die Zeichnung näher erläutert. Im einzelnen zeigen dabei:
- Fig. 1: eine Schaltung einer bekannten kapazitiven Halios-Messbrücke mit RC-Tiefpässen,
- Fig. 2: den Signalverlauf am Ausgang des Transimpedanz-Verstärkers an der Schaltung nach Fig. 1 im ausgeregelten und nicht ausgeregelten Zustand, wobei die Regelung Abtastwerte zu Zeitpunkten verwendet, die in dem Diagramm mit senkrechten schwarzen Strichen markiert sind,
- Fig. 3: eine Schaltung einer bekannten kapazitiven Halios-Messbrücke mit Längskapazitäten,
- Fig. 4: ein erstes Ausführungsbeispiel eines erfindungsgemäßen Sensors als Blockschaltbild einer kapazitiven Messbrücke,
- Fig. 5: die Signalverläufe während eines Messvorgangs ohne Störungen bei der Schaltung nach Fig. 4,
- Fig. 6: das Blockschaltbild der kapazitiven Messbrücke unter EM-Störeinkopplung,
- Fig. 7: die Signalverläufe bei Vorhandensein von Störungen in der Schaltung nach Fig. 6,
- Fig. 8: ein Blockschaltbild des Regelkreises zur Messung elektrischer Parameter im Sensornetzwerk,
- Fig. 9: ein Schaltbild eines Sensor/Referenz-Netzwerks zur Messung von massebezogenen Kapazitäten,
- Fig. 10: ein Sensornetzwerk zur Messung des kapazitiven Spannungsteilers über einen hochohmigen Differenzverstärker-Eingang mit aktiver Summation,
- Fig. 11: ein Sensornetzwerk zur Messung des kapazitiven Spannungsteilers mit passiver Summation an den Knoten CM und CMK,
- Fig. 12: ein Blockschaltbild eines Differenzwert-Sensors ohne Referenznetzwerk,
- Fig. 13: ein Blockschaltbild eines Sensornetzwerks mit Regelung von RLC-Parameterwerten im adaptiven Sensor-Regelkreis und
- Fig. 14: ein Blockschaltbild wie in Fig. 13, wobei ein Null-Abgleich bei der Unterdrückung von elektromagnetischen Störungen durch eine asymmetrische Veränderung des Verstärkungsfaktors im Differenzverstärker durchgeführt wird.

In der nachfolgenden Figurenbeschreibung werden mehrere Ausführungsbeispiele der Erfindung beschrieben, wobei gleiche (d.h. funktions- bzw. konstruktionsgleiche) Einzelteile bzw. Einzelelemente der Sensoren in den Figuren mit den gleichen Bezugszeichen versehen sind.

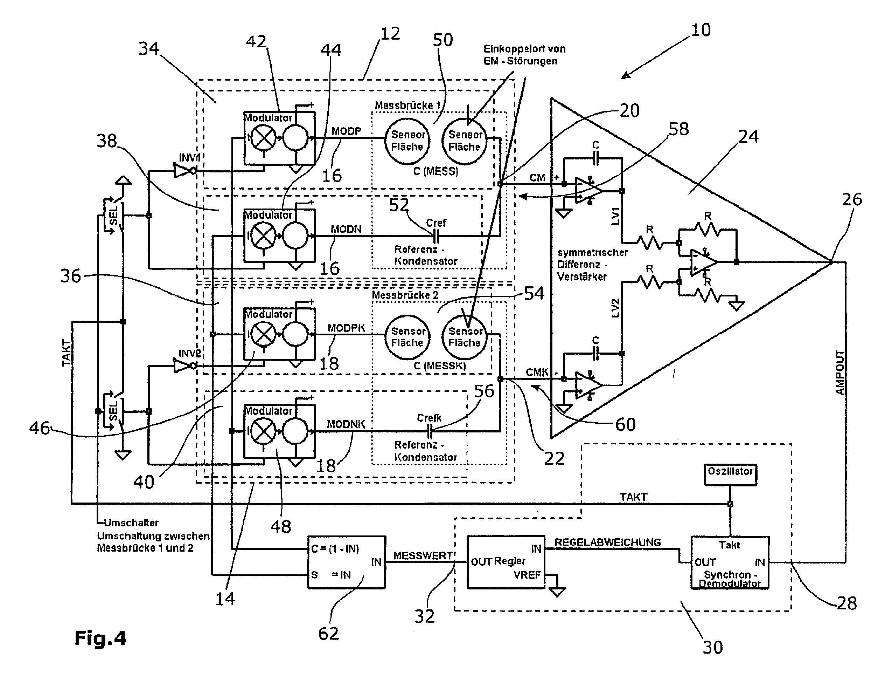

In den Fign. 4 bis 7 ist ein erstes Ausführungsbeispiel eines störkompensierten Sensors 10 gezeigt. Der Sensor 10 weist einen ersten Messkanal 12 sowie einen zweiten Messkanal 14 auf, die im wesentlichen gleich aufgebaut sind. Jeder Messkanal 12,14 weist einen Eingang 16 bzw. 18 in jedem seiner beiden Messzweige (siehe weiter unten) sowie einen Ausgang 20 bzw. 22 auf. Jeder Messkanal 12,14 weist ferner Ansteuereinheiten 42,44 und 46,48 mit je zwei Eingängen zur Erzeugung von zwei amplitudenmodulierten Taktsignalen auf (siehe weiter unten). Der Amplitudenwert wird hierbei mit Hilfe der Funktionseinheit 62 aus dem Messwert gebildet. Die beiden Ausgänge 20,22 der beiden Messkanäle 12,14 sind mit den Eingängen eines Hauptdifferenzbildners 24 verbunden. Der Ausgang 26 dieses Hauptdifferenzbildners 24 ist mit dem Eingang 28 einer Reglereinheit 30 verbunden, an deren Ausgang 32 der eigentliche Messwert in Form eines Signals anliegt, das zur Steuerung der Messkanäle 12,14 zwecks Null-Abgleich genutzt wird, wie dies grundsätzlich von dem unter dem Namen Halios bekannten Verfahren her bekannt ist.

In dem Ausführungsbeispiel gemäß Fig. 4 weist jeder Messkanal 12,14 des Sensors 10 einen Messzweig 34 bzw. 36 (nachfolgend mit erster Messzweig 34 und zweiter Messzweig 36 bezeichnet) sowie einen Referenzzweig 38 bzw. 40 (nachfolgend mit erster Referenzzweig 38 und zweiter Referenzzweig 40 bezeichnet) auf. Jeder dieser Mess- und Referenzzweige umfasst eine Ansteuereinheit 42,44,46 bzw. 48. Der erste Messzweig 34 ist mit einer Messkapazität 50 (CMESS) versehen, während der erste Referenzzweig 38 mit einer Referenzkapazität 52 (Cref) versehen ist. Die Mess- und Referenzzweige des zweiten Messkanals sind mit einer weiteren Messkapazität 54 (CMESSK) bzw. einer weiteren Referenzkapazität 56 (Crefk) versehen. Die beiden Mess- und Referenzzweige jedes der beiden Messkanäle 12,14 sind an den Ausgängen 20,22 zusammengeführt, diese Ausgänge 20,22 bilden erste und zweite Messkanal-Differenzbildner 58,60.

Das Funktionsprinzip der in Fig. 4 gezeigten erfindungsgemäßen Ausführung des Messverfahrens besteht darin, mit einer zweiten Sensorkapazität (CMESSK), die geometrisch sehr ähnlich zur ersten Sensorkapazität (CMESS) ausgelegt ist, die Störungen noch einmal einzufangen und die Störsignale aus den beiden Sensorzweigen sich im nachgeschalteten Differenzverstärker gegenseitig auslöschen zu lassen.

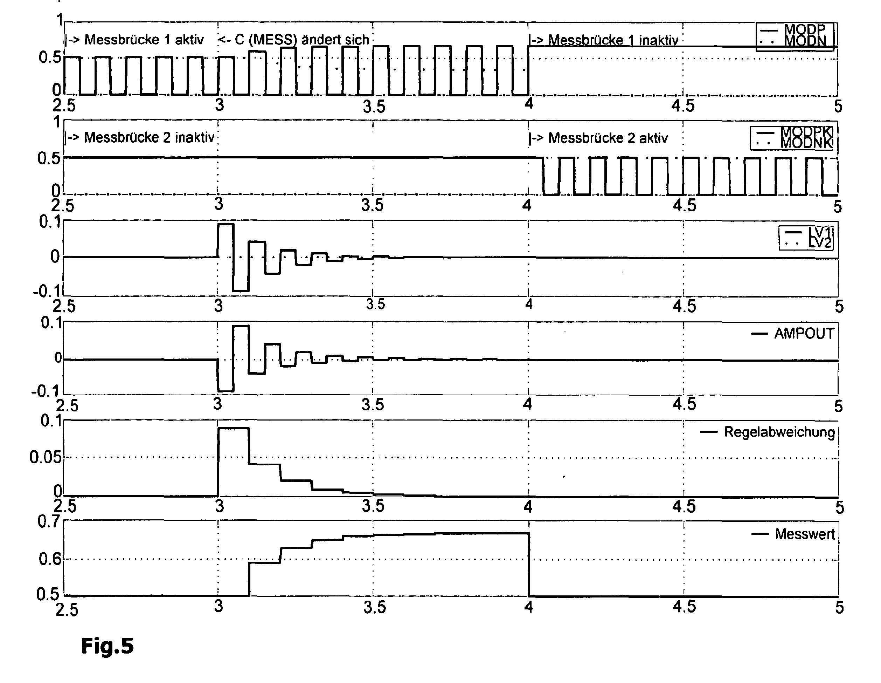

Den prinzipiellen Messablauf ohne Störungen zeigt Fig. 5. Zunächst erfolgt mit den Signalen MODP und MODN die Ansteuerung der Messbrücke 1. Die Messbrücke 2 ist während dieser Zeit inaktiv. Die Messkapazität CMESS und die Referenzkapazität sind zum Zeitpunkt t / t_{N} = 3 gleich groß. Im ausgeregelten Zustand sind daher die Modulationsamplituden an den Knoten MODP und MODN ebenfalls gleich groß und am Ausgang des ersten Ladungsverstärkers (Knoten LV1) löschen sich die Ströme über die beiden Zweige der Messbrücke 1 zu Null aus. Der Regelkreis befindet sich im ausgeregelten Zustand. Zum Zeitpunkt t / t_{N} = 3 ändert sich die Messkapazität, Dadurch entsteht am Ladungsverstärker LV1 ein Signal, welches vom Synchron-Demodulator gleichgerichtet wird. Der Regler verändert die Modulationsamplituden solange, bis die Regelabweichung wieder zu Null geworden ist. Zum Zeitpunkt t / t_{N} = 4 wird die Messbrücke 2 aktiviert, während die Messbrücke 1 abgeschaltet wird. Diese Umschaltung führt im allgemeinen Fall zu einem Einschwingvorgang, der hier nicht gezeigt ist. Es wird angenommen, dass der Regler mit dem letzten Arbeitspunkt startet, den er vor der Deaktivierung der Messbrücke 2 hatte. Da die Kapazität CMESSK sich während der Messung nicht ändert, bleibt die Messbrücke im eingeregelten Zustand.

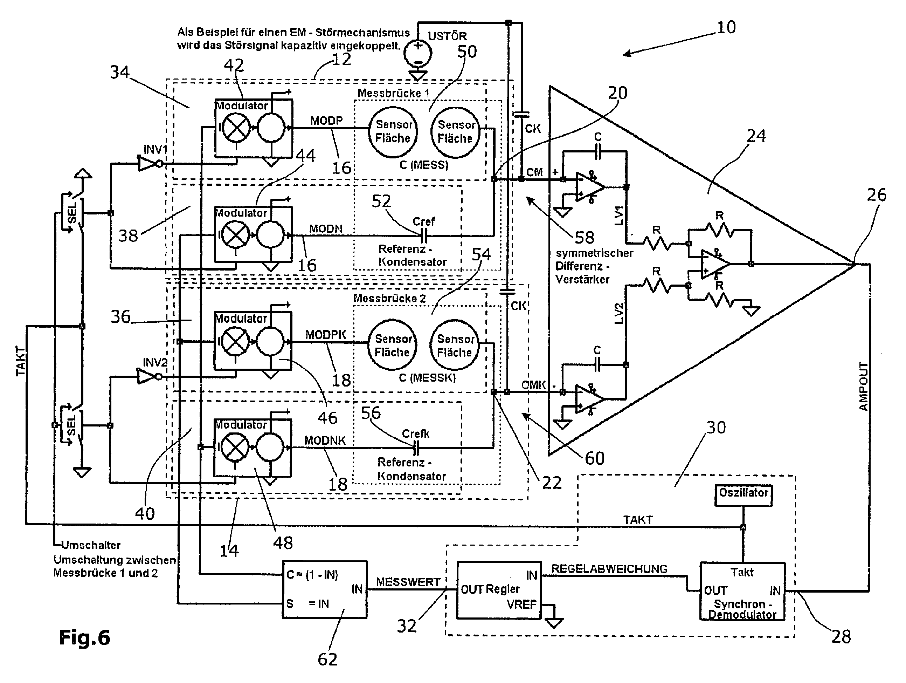

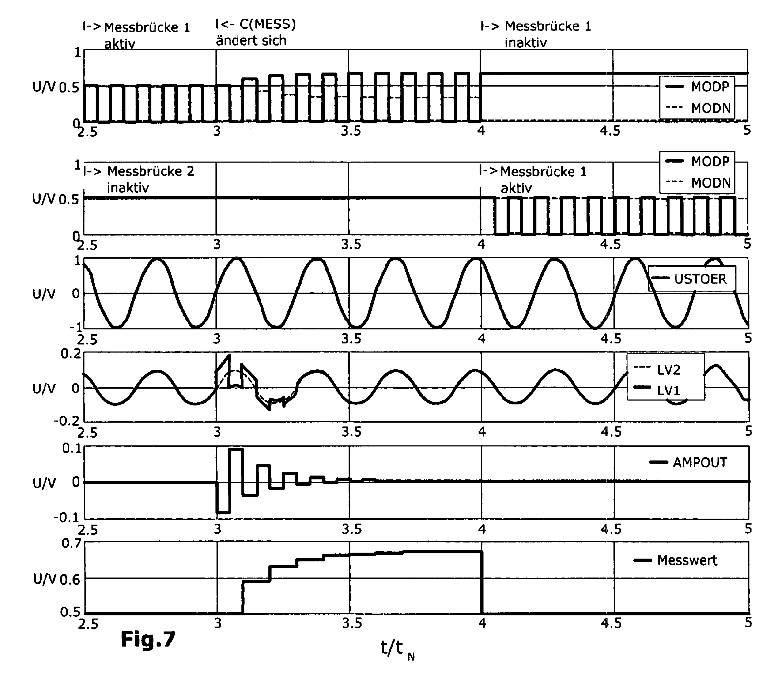

Die Störungen koppeln im Allgemeinen als elektromagnetische Strahlung an den Knoten CM und CMK in den Verstärker ein. Fig. 6 zeigt als Beispiel den Fall einer kapazitiven Einkoppelung. Den Signalverlauf der sinusförmigen Störung (USTÖR) zeigt Fig. 7. An den Ausgängen LV1 und LV2 der beiden Ladungsverstärker ist jetzt dieses Störsignal überlagert. Aufgrund der Gleichtaktunterdrückung des nachfolgenden Differenzverstärkers wird die Störung gedämpft. Das Nutzsignal hingegen wird verstärkt an den Demodulator weitergegeben, so dass die Messung unbeeinflusst von den Störungen durchgeführt werden kann.

Die erfindungsgemäße Ausführung des Sensors (nicht nur nach den Fign. 4 bis 7, sondern ganz allgemein) besitzt die Eigenschaft, elektromagnetische Störungen selbst im Bereich der Synchronfrequenz und deren Vielfachen effektiv unterdrücken zu können. Eine optimale Arbeitsweise wird erzielt, wenn die Antennenwirkung beider Sensornetzwerke gegenüber EM-Störungen gleich groß ist. Vorteilhaft ist, wenn die Sensorflächen geometrisch nahe beieinander liegen, zueinander symmetrisch ausgelegt werden und - wenn möglich - keine große geometrische Ausdehnung haben. Dadurch erreicht man, dass die Intensität der Störung an beiden Summationspunkten gleich groß ist, wodurch die Auslöschung im nachfolgenden Differenzverstärker mit der Güte dessen Gleichtaktunterdrückung erfolgt.

Da die zur Störunterdrückung vorgesehene Sensorelektrode, CMESSK (durch die entsprechende Phasendrehung) direkt zur Signalgewinnung herangezogen werden kann, ist diesbezüglich die gesamte Sensorfläche optimal genutzt.

### Beschreibung der bevorzugten Ausführungen

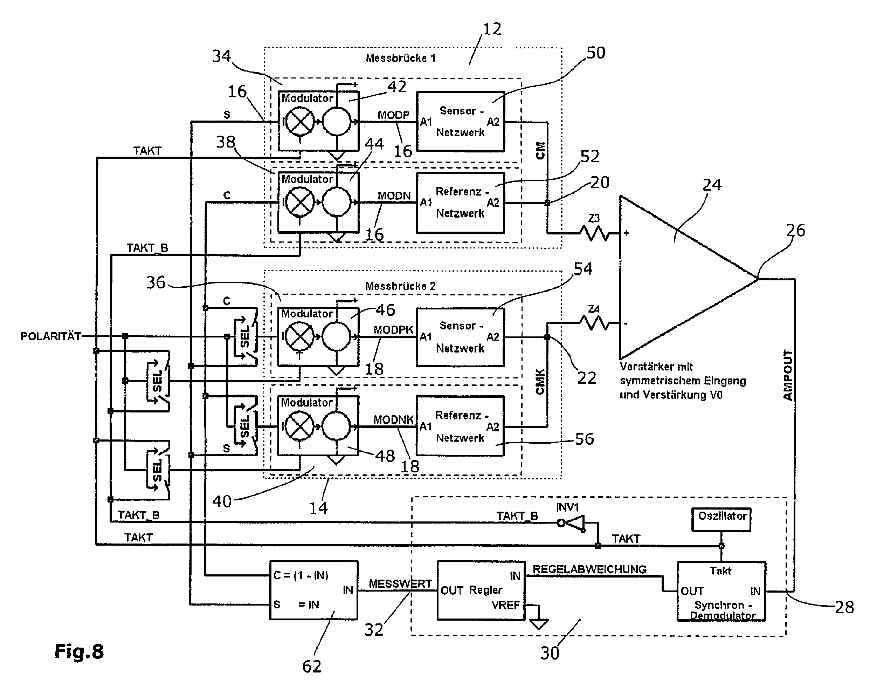

Das in Fig. 8 gezeigte Blockschaltbild gibt den Aufbau des Sensors zur Messung elektrischer Parameter In einem beliebigen linearen RLC-Netzwerk wieder. Gemessen werden Änderungen der Parameter von RLC-Netzwerkselementen 50,54 im Vergleich zum Referenz-RLC-Netzwerk 52,56.

Eine gute EMV setzt nach wie vor voraus, dass die störende Einstrahlung in die beiden Sensornetzwerke der Sensor(Mess-)brücken 12 und 14 in gleichem Maße (symmetrisch) erfolgt.

Die Ansteuerung der Messbrücken 12 und 14 kann sowohl gleichzeitig als auch zeitsequentiell erfolgen. Die Fig. 8 zeigt den Fall für die gleichzeitige Messung. Die Taktsignale aller vier Modulatoren sind dann während der Messung aktiv. Im allgemeinen Fall, wenn die RLC-Parameter der beiden Sensornetzwerke jeweils in ihren Zweigen 34,38 bzw. 36,40 nicht vollkommen übereinstimmen, erfolgt eine Auslöschung des Nutzsignals zu Null erst am Knoten AMPOUT 26, und nicht etwa an den Summationspunkten CM 20 und CMK 22.

Mit Hilfe des in Fig. 8 gezeigten Signals "Polarität" kann zwischen Differenzbetrieb und Summationsbetrieb umgeschaltet werden. Im Summationsmodus werden die Änderungen elektrischer Parameter in den beiden Sensornetzwerken im Regelsignal "Messwert" aufaddiert. Im Differenzbetrieb werden nur die Unterschiede zwischen den beiden "Sensorhälften" 12,14 registriert. Dieser Betriebsmodus ist besonders dann geeignet, wenn das Nutzsignal als Differenzsignal generiert wird und der Gleichtaktanteil (z.B. Temperatureinfluss) unterdrückt werden soll.

Bei der zeitsequentiellen Messung wird, wie in den Fign. 4 und 5 gezeigt, nur ein Kanal moduliert, während die Modulationsquellen des anderen Kanals inaktiv sind. Bei dieser Art der Steuerung erfolgt die Nullauslöschung schon am Summationspunkt CM bzw. CMK des jeweils aktiven Kanals.

### Beispiele für Sensor-/Referenz-Netzwerke

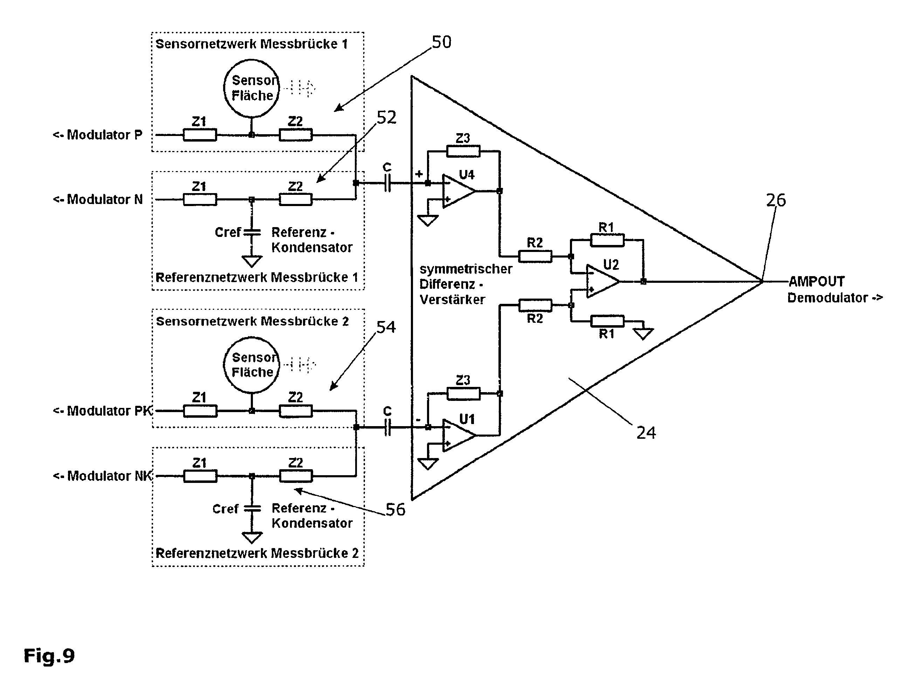

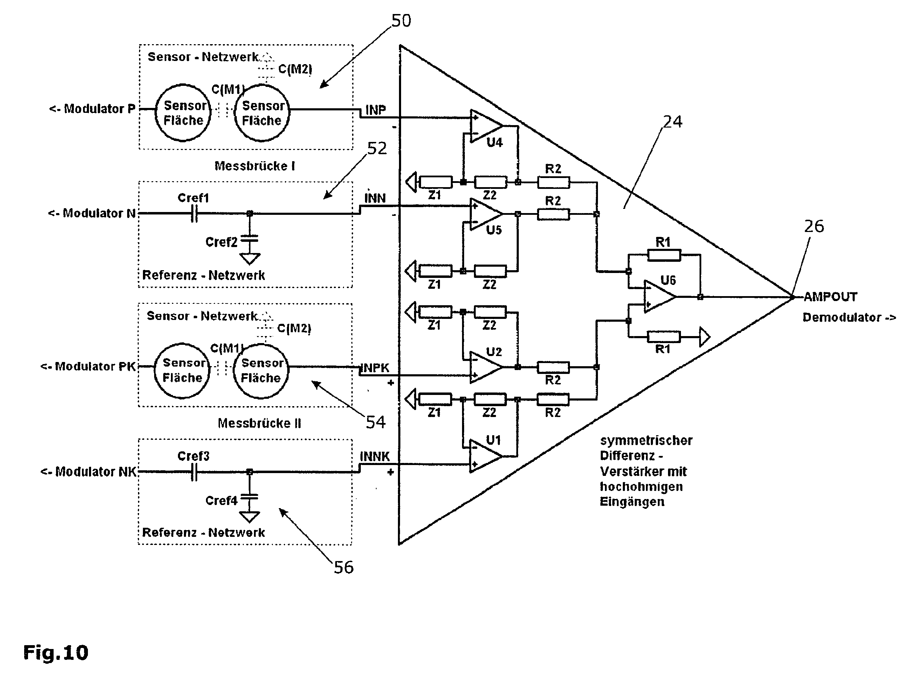

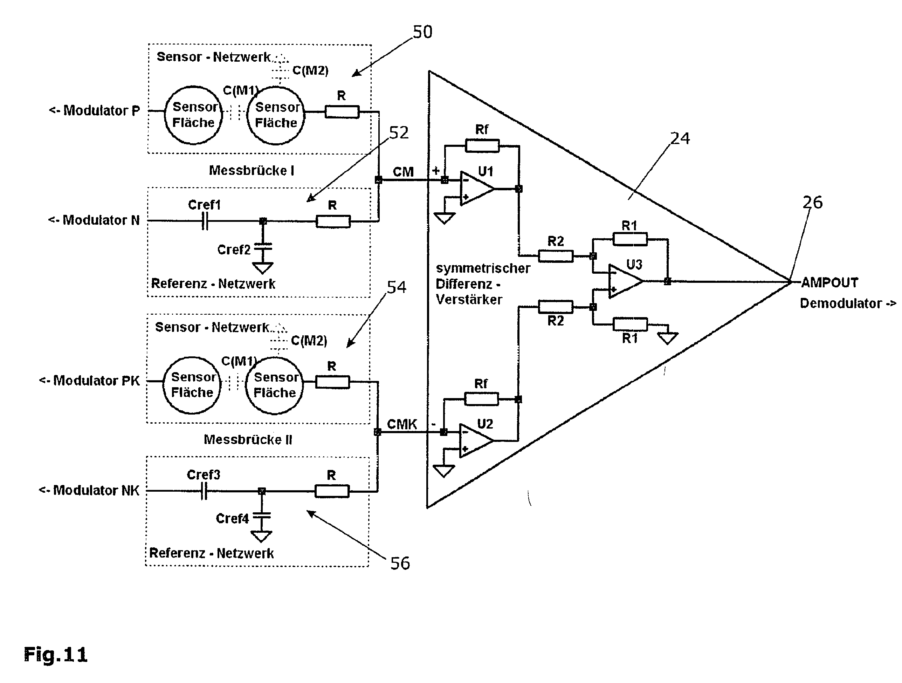

Beispiele für Sensor-/Referenz-Netzwerke zeigen die Fign. 9 bis 11. Die in Fig. 9 gezeigte Schaltung ist geeignet, massebezogen Kapazitäten zu messen. Das in Fig. 10 gezeigte Netzwerk wird verwendet, um den kapazitiven Spannungsteiler, bestehend aus den Kapazitäten C(M1) und C(M2), zu vermessen. Die Auswertung erfolgt über einen Elektrometerverstärker mit aktiver Summation. Fig. 11 zeigt eine andere Variante für die Auswertung des kapazitiven Spannungsteilers. In diesem Fall erfolgt die Auskoppelung der Spannung über hochohmige Widerstände. Die Summation kann dadurch passiv am Knoten CM und CMK erfolgen.

### Sensorvariante ohne Referenz-Netzwerk

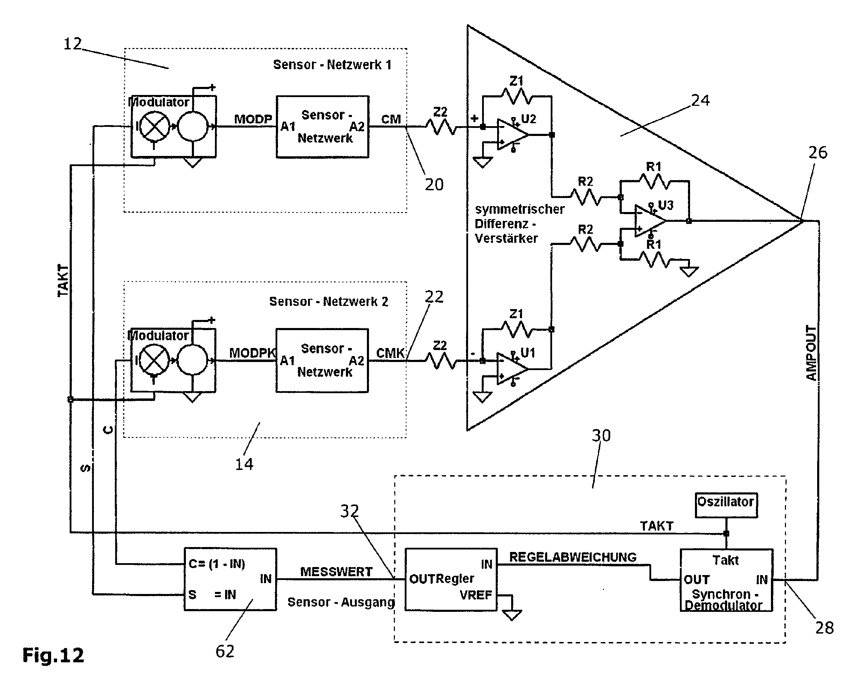

Eine alternative Realisierungsmöglichkeit der Sensormessbrücke zeigt Fig. 12. Im Vergleich zum Blockschaltbild der Fig. 8 entfällt das Referenznetzwerk sowie der invertierte Takt zur Ansteuerung des Referenznetzwerks. Die Summation des Nutzsignals erfolgt nun nicht mehr durch ein passives Netzwerk an den Knotenpunkten CM bzw. CMK, sondern sie erfolgt aktiv am Ausgang AMPOUT des Differenzverstärkers.

Im Vergleich zu der in Fig. 8 gezeigten Realisierung, welche zwischen Summationsbetrieb und Differenzbetrieb umgeschaltet werden kann, erlaubt die hier beschriebene Variante nur den Differenzbetrieb. Das Sensor-Ausgangssignal "Messwert" 32 reagiert also nur auf Unterschiede zwischen den beiden Sensornetzwerken 12 und 14. Ändern sich die zu messenden Parameter in beiden Sensornetzwerken in gleichem Maße, so reagiert der Sensor darauf nicht. Daher handelt es sich hierbei um einen reinen Differenzwertsensor.

Elektromagnetische Störungen, die über die Knoten CM und CMK in den Regelkreis gelangen, werden erfindungsgemäß über die Gleichtaktunterdrückung des Differenzverstärkers gedämpft.

### Alternative Regelungsmethode

Bei den bisherigen Ausführungen der Sensoren wurde die Amplitude des Modulationssignals für das Sensor- und Referenznetzwerk geregelt. Eine weitere Möglichkeit besteht darin, den Parameterwert eines oder mehrerer RLC-Netzwerkelemente zu steuern, um den Nullsignalausgleich am Demodulator-Eingang herbeizuführen.

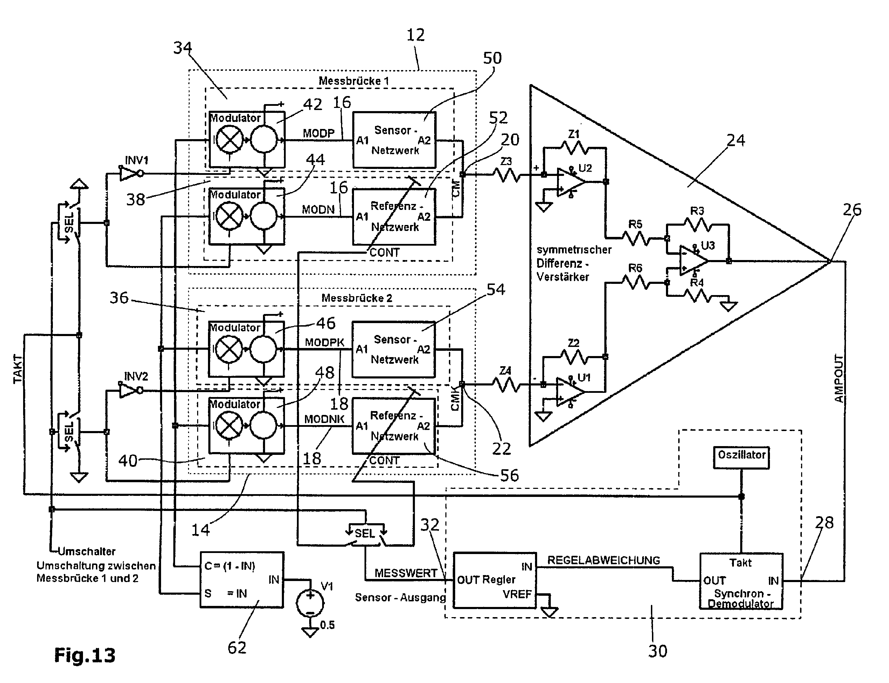

Das in Fig. 13 gezeigte Blockschaltbild veranschaulicht dieses Funktionsprinzip. Die Messbrücken 16,18 werden sequentiell aktiviert. Im Blockschaltbild ist entsprechend der Schalterstellung des Wechselschalters am Ausgang "Messwert" die Messbrücke 1 aktiv. Die beiden Modulatoren werden wie bisher mit invertiertem Takt angesteuert. Die Amplitude wird hier jedoch bei beiden Modulatoren auf einem konstant Wert gehalten. Die Regelung erfolgt in diesem Fall dadurch, dass im Referenznetzwerk der Wert des relevanten Bauelements verstellt wird, bis wieder der Abgleich von Sensor- und Referenz-Netzwerk hergestellt ist, bzw. am Knoten AMPOUT 26 ein Nullsignal vorhanden ist.

Es ist auch möglich, beide Regelungsarten miteinander zu kombinieren. Beispielsweise kann zunächst über die Regelung des Wertes eines Bauelementes im Referenznetzwerk ein Vorabgleich durchgeführt werden, um anschließend, in einer zweiten Phase, mit der Feinabstimmung über die Regelung der Modulationsamplitude fortzufahren.

Dieses Vorgehen ermöglicht es, den Sensor über den Vorabgleich in einen empfindlicheren Bereich der Kennlinie hinzuführen und danach die Messung mit höherer Auflösung über die Regelung der Amplitude fortzuführen. Ein weiterer Nutzen entsteht dadurch, dass man durch den parametrischen Abgleich des Referenznetzwerkes die Genauigkeit des Messverfahrens in diesem Arbeitspunkt erhöhen kann.

### Abgleichmöglichkeiten zur Verbesserung der EMV

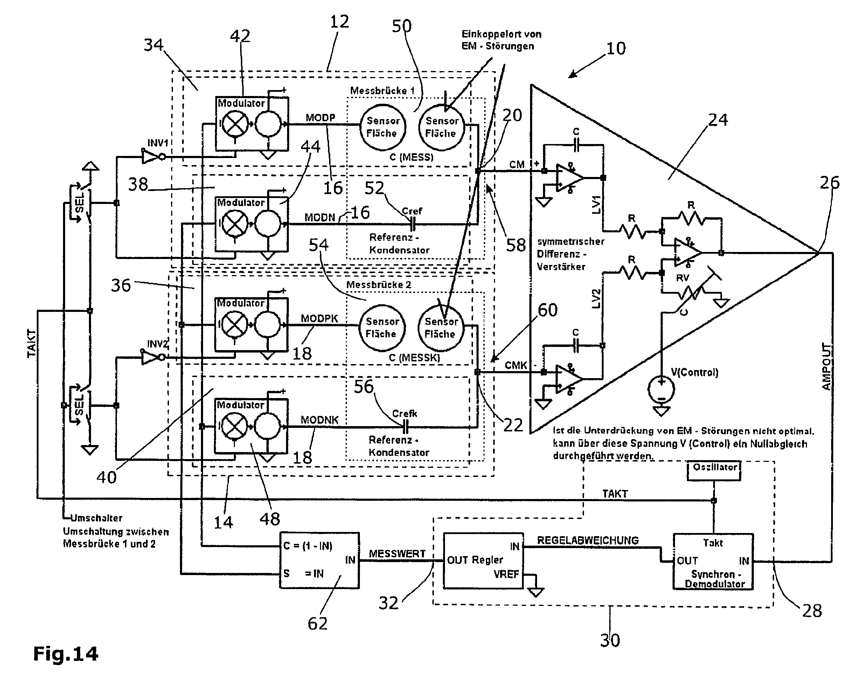

Erfolgt die Einkoppelung der elektromagnetischen Störungen nicht ideal symmetrisch an den Knotenpunkten CM und CMK, so ist die Unterdrückung der Störung für die vorliegende Applikation unter Umständen nicht ausreichend gut. In diesem Fall ist es möglich, die Störungen zu Null abzugleichen, indem der Verstärkungsfaktor bezogen auf den positiven und negativen Eingang des Differenzverstärkers asymmetrisch verändert wird. Fig. 14 zeigt eine Möglichkeit, den Verstärkungsfaktor des negativen Eingangs relativ zum positiven Eingang zu verändern.

Der Abgleich kann auch an anderen Stellen in der Verstärkerschaltung erzielt werden. Beispielsweise können die Rückkoppelkondensatoren in den Ladungsverstärkern einstellbar gemacht werden und durch gegenseitige Verstimmung äußere Unsymmetrien des Sensors ausgeglichen werden.

### BEZUGSZEICHENLISTE

- 10: Sensor
- 12: erster Messkanal
- 14: zweiter Messkanal
- 16: Eingang des ersten Messkanals
- 18: Eingang des zweiten Messkanals
- 20: Ausgang des ersten Messkanals
- 22: Ausgang des zweiten Messkanals
- 24: Hauptdifferenzbildner
- 26: Ausgang des Hauptdifferenzbildners
- 28: Eingang der Reglereinheit
- 30: Reglereinheit
- 32: Ausgang der Reglereinheit
- 34: Messzweig des ersten Messkanals
- 36: Messzweig des zweiten Messkanals
- 38: Referenzzweig des ersten Messkanals
- 40: Referenzzweig des zweiten Messkanals
- 42: Ansteuereinheit des Messzweiges des ersten Messkanals
- 44: Ansteuereinheit des Referenzzweiges des ersten Messkanals
- 46: Ansteuereinheit des Messzweiges des zweiten Messkanals
- 48: Ansteuereinheit des Referenzzweiges des zweiten Messkanals
- 50: Messkapazität des Messzweiges des ersten Messkanals
- 52: Referenzkapazität des Referenzzweiges des ersten Messkanals
- 54: Messkapazität des Messzweiges des zweiten Messkanals
- 56: Referenzkapazität des Referenzzweiges des zweiten Messkanals
- 58: Differenzbildner des ersten Messkanals
- 60: Differenzbildner des zweiten Messkanals
- 62: Einheit zur Erzeugung der Amplituden als Funktion des Messwertes

## Patentansprüche

1. Störkompensierter Sensor zur berührungslosen Erfassung eines in einem Erfassungsbereich befindlichen Objekts, insbesondere Regensensor, mit
- einem ersten und einem zweiten Messkanal (12,14) mit jeweils einer Ansteuervorrichtung und jeweils einem Ausgang (20,22), wobei beide Messkanäle (12,14) insbesondere im Wesentlichen identisch sind,
- einem Hauptdifferenzbildner (24) mit einem Ausgang (26) zur Ausgabe der Differenz der Signale an den Ausgängen (20,22) der Messkanäle (12,14),
- einer Reglereinheit (30) mit einem Eingang, der mit dem Ausgang (26) des Hauptdifferenzbildners (24) verbunden ist, und mit einem Ausgang zur Ausgabe eines Reglersignals, anhand dessen die beiden Messkanäle (12,14) derart ansteuerbar sind, dass das Signal am Ausgang (26) des Hauptdifferenzbildners (24) zu Null regelbar ist,
- wobei anhand der Größe des Signals am Ausgang des Reglers ermittelbar ist, ob sich im Erfassungsbereich ein Objekt befindet,
**dadurch gekennzeichnet, dass**
- jeder Messkanal (12,14) einen Messzweig (34,36) mit einer Messzweig-Ansteuereinheit (42,46) zur Erzeugung eines Messsignals an einem Ausgang des Messzweiges (34,36) und einen Referenzzweig (38,40) mit einer Referenzzweig-Ansteuereinheit (44,48) zur Erzeugung eines Referenzsignals an einem Ausgang des Referenzzweiges (38,40) aufweist,
- ein erster und ein zweiter Messkanal-Differenzbildner (58,60) vorhanden ist, wobei jedem Messkanal (12,14) jeweils ein Differenzbildner zur Bildung des Differenzsignals zwischen den Mess- und Referenzsignalen an den Ausgängen des Mess- und des Referenzzweiges (34,36,38,40) des betreffenden Messkanals (12,14) zugeordnet ist und das Differenzsignal am Messkanalausgang des betreffenden Messkanals (12,14) anliegt,
- der Hauptdifferenzbildner (24) zwischen dem ersten und dem zweiten Messkanal-Differenzbildner (58,60) einerseits und der Reglereinheit (30) andererseits angeordnet ist und
- die Mess- und Referenzzweige (34,36,38,40) der beiden Messkanäle (12,14) anhand des Reglerausgangssignals derart ansteuerbar sind, dass das Differenzsignal der Mess- und Referenzsignale jedes Messkanals (12,14) auf Null regelbar ist.

2. Sensor nach Anspruch 1, **dadurch gekennzeichnet, dass** jeder Messkanal ein kapazitives, induktives, optisches und/oder resistives Messsensorelement bzw. Referenzelement aufweist.

3. Sensor nach Anspruch 1, **dadurch gekennzeichnet, dass** jeder Mess- und Referenzzweig (34,36,38,40) ein kapazitives, induktives, optisches und/oder resistives Messsensorelement bzw. Referenzelement aufweist.

4. Sensor nach einem der Ansprüche 1 bis 3, **dadurch gekennzeichnet, dass** die beiden Messkanäle (12,14) zeitgleich oder zeitlich alternierend ansteuerbar sind.

5. Sensor nach Anspruch 1 oder 3, **dadurch gekennzeichnet, dass** jeder Messkanal (12,14) intermittierend und sein Mess- sowie sein Referenzzweig (34,36,38,40) im Gegentaktbetrieb ansteuerbar ist.

6. Sensor nach einem der Ansprüche 1 bis 5, **dadurch gekennzeichnet, dass** die Nullregelungsansteuerung der beiden Messkanäle (12,14) bzw. der Mess- und Referenzzweige (34,36,38,40) der beiden Messkanäle (12,14) amplitudenmoduliert erfolgt.

7. Sensor nach einem der Ansprüche 1 bis 4, **dadurch gekennzeichnet, dass** jeder der ersten und zweiten Differenzbildner als Verbindungsknotenpunkt der Ausgänge des Mess- und des Referenzzweiges (34,36,38,40) des betreffenden Messkanals (12,14) ausgebildet ist.

8. Sensor nach einem der Ansprüche 1 bis 5, **dadurch gekennzeichnet, dass** jeder der ersten und zweiten Differenzbildner und/oder der weiteren Differenzbildner einen Signalverstärker aufweist.

9. Sensor nach einem der Ansprüche 1 bis 6, **dadurch gekennzeichnet, dass** mit Hilfe des Reglersignals die Ansteuereinheiten der Mess- und Referenzzweige (34,36,38,40) beider Messkanäle (12,14) ansteuerbar sind.

10. Sensor nach einem der Ansprüche 1 bis 7, **dadurch gekennzeichnet, dass** die Referenzkanäle verstellbare Referenzelemente aufweisen und dass mit Hilfe des Reglersignals die Referenzelemente der Referenzkanäle der beiden Messzweige (34,36) veränderbar sind.

11. Sensor nach einem der Ansprüche 1 bis 10, **dadurch gekennzeichnet, dass** geometrische und elektrische Asymmetrien zwischen den Messkanälen (12,14) durch verstellbare Gewichtung im Hauptdifferenzbildner (24) kompensierbar sind.

## Claims

1. An interference-compensated sensor for contactless detection of an object located in a detection area, said sensor being particularly a rain sensor, said sensor comprising
- a first and a second measuring channel (12,14) each having a control device and an output (20,22), both said measuring channels (12,14) particularly being substantially identical,
- a main subtractor (24) having an output (26) for outputting the difference of the signals at the outputs (20,22) of the measuring channels (12,14),
- a controller unit (30) having an input connected to the output (26) of the main subtractor (24) and having an output for outputting a controller signal, by means of which the two measuring channels (12,14) can be controlled in such a manner that the signal at the output (26) of the main subtractor (24) can be controlled to zero,
- it being determinable, on the basis of the magnitude of the signal at the output of the controller, whether an object is located in the detection area,
**characterized in that**
- each measurement channel (12,14) comprises a measurement branch (34,36) with a measurement branch control unit (42,46) for generating a measurement signal at an output of the measurement branch (34,36), and a reference branch (38,40) with a reference branch control unit (44,48) for generating a reference signal at an output of the reference branch (38,40),
- a first and a second measurement channel subtractor (58,60) are provided, each measurement channel (12,14) having assigned to it a respective subtractor for obtaining the difference signal between the measurement and reference signals at the outputs of the measurement and reference branches (34,36,38,40) of the respective measurement channel (12,14), and the difference signal being provided at the measurement channel output of the respective measurement channel (12,14),
- the main subtractor (24) is arranged between the first and second measurement channel subtractors (58,60) on the one hand and the control unit (30) on the other hand, and
- the measurement and reference branches (34,36,38,40) of the two measurement channels (12,14) are controllable on the basis of the controller output signal in such a manner that the difference signal of the measurement and reference signals of each measurement channel (12,14) can be controlled to zero.

2. The sensor of claim 1, **characterized in that** each measurement channel comprises a capacitive, inductive, optical and/or resistive measurement sensor element and reference element, respectively.

3. The sensor of claim 1, **characterized in that** each measurement and reference branch (34,36,38,40) comprises a capacitive, inductive, optical and/or resistive measurement sensor element and reference element, respectively.

4. The sensor of any one of claims 1 to 3, **characterized in that** the two measurement channels (12,14) is controllable simultaneously or in a temporally alternating manner.

5. The sensor of claim 1 or 3, **characterized in that** each measurement channel (12,14) is controllable intermittently and its measurement and reference branches (34,36,38,40) are controllable in push-pull operation.

6. The sensor of any one of claims 1 to 5, **characterized in that** the zero controlling of the two measurement channels (12,14) and respectively of the measurement and reference branches (34,36,38,40) of the two measurement channels (12,14) is performed by amplitude modulation.

7. The sensor of any one of claims 1 to 4, **characterized in that** each of the first and second subtractors is formed as a connecting node of the outputs of the measurement and reference branch (34,36,38,40) of the respective measurement channel (12,14).

8. The sensor of any one of claims 1 to 5, **characterized in that** each of the first and second subtractors and/or of the further subtractors comprises a signal amplifier.

9. The sensor of any one of claims 1 to 6, **characterized in that** the control units of the measurement and reference branches (34,36, 38,40) of the two measurement channels (12,14) can be controlled with the aid of the controller signal.

10. The sensor of any one of claims 1 to 7, **characterized in that** the reference channels comprise adjustable reference elements and that the reference elements of the reference channels of the two measurement branches (34,36) can be changed with the aid of the controller signal.

11. The sensor of any one of claims 1 to 10, **characterized in that** geometrical and electrical asymmetries between the measurement channels (12,14) can be compensated for by adjustable weighting in the subtractor (24).

## Revendications

1. Capteur à compensation de perturbation pour la détection sans contact d'un objet situé dans un domaine de détection, en particulier capteur de pluie, comprenant
- un premier et un deuxième canaux de mesure (12, 14) possédant chacun un dispositif de commande et chacun une sortie (20, 22), les deux canaux de mesure (12, 14) étant en particulier sensiblement identiques,
- un formateur de différence principal (24) possédant une sortie (26) destinée à restituer la différence entre les signaux apparaissant aux sorties (20, 22) des canaux de mesure (12, 14),
- une unité de régulateur (30) qui comprend une entrée connectée à la sortie (26) du formateur de différence principal (24), et une sortie destinée à émettre un signal de régulateur sur la base duquel les deux canaux de mesure (12, 14) peuvent être commandés de telle manière que le signal apparaissant à la sortie (26) du formateur de différence principal (24) puisse être réglé sur zéro,
- dans lequel il est possible de déterminer sur la base de la valeur du signal apparaissant à la sortie du régulateur si un objet est présent dans le domaine de détection,
**caractérisé en ce que**
- chaque canal de mesure (12, 14) présente une branche de mesure (34, 36), comportant une unité de commande de branche de mesure (42, 46) et destinée à générer un signal de mesure à une sortie de la branche de mesure (34, 36), et une branche de référence (38, 40), comportant une unité de commande de branche de référence (44, 48) et destinée à générer un signal de référence à une sortie de la branche de référence (38, 40),
- il est prévu un premier et un second formateurs de différence de canaux de mesure (58, 60), où à chaque canal de mesure (12, 14) est associé un formateur de différence destiné à former le signal de différence entre les signaux de mesure et de référence qui apparaissent aux sorties de la branche de mesure et de la branche de référence (34, 36, 38, 40) du canal de mesure (12, 14) considéré, et où le signal de différence apparaît à la sortie du canal de mesure (12, 14) considéré,
- le formateur de différence principal (24) est interposé entre le premier et le second formateurs de différence de canaux de mesure (58, 60) d'une part, et l'unité de régulateur (30) d'autre part, et
- les branches de mesure et de référence (34, 36, 38, 40) des deux canaux de mesure (12, 14) peuvent être commandées sur la base du signal de sortie du régulateur de telle manière que le signal de différence entre les signaux de mesure et de référence de chaque canal de mesure (12, 14) puisse être réglé sur zéro.

2. Capteur selon la revendication 1, **caractérisé en ce que** chaque canal de mesure présente un élément capteur de mesure ou de référence capacitif, inductif, optique et/ou résistif.

3. Capteur selon la revendication 1, **caractérisé en ce que** chaque branche de mesure et de référence (34, 36, 38, 40) présente respectivement un élément capteur de mesure ou de référence capacitif, inductif, optique et/ou résistif.

4. Capteur selon l'une des revendications 1 à 3, **caractérisé en ce que** les deux canaux de mesure (12, 14) peuvent être commandés simultanément ou en alternance dans le temps.

5. Capteur selon la revendication 1 ou 3, **caractérisé en ce que** chaque canal de mesure (12, 14) peut être commandé par intermittence et que sa branche de mesure et sa branche de référence (34, 36, 38, 40) peuvent être commandées en symétrique.

6. Capteur selon l'une des revendications 1 à 5, **caractérisé en ce que** la commande de régulation sur zéro des deux canaux de mesure (12, 14) ou des branches de mesure et de référence (34, 36, 38, 40) des deux canaux de mesure (12, 14) s'effectue par modulation d'amplitude

7. Capteur selon l'une des revendications 1 à 4, **caractérisé en ce que** chacun des premier et second formateurs de différence est constitué par un noeud de connexion des sorties de la branche de mesure et de la branche de référence (34, 36, 38, 40) du canal de mesure (12, 14) considéré.

8. Capteur selon l'une des revendications 1 à 5, **caractérisé en ce que** chacun des premier et second formateurs de différence et/ou des autres formateurs de différence comprend un amplificateur de signal.

9. Capteur selon l'une des revendications 1 à 6, **caractérisé en ce que** les unités de commande des branches de mesure et de référence (34, 36, 38, 40) des deux canaux de mesure (12,14) peuvent être commandées sur la base du signal de régulateur.

10. Capteur selon l'une des revendications 1 à 7, **caractérisé en ce que** les canaux de référence présentent des éléments de référence réglables et **en ce que** les éléments de référence des canaux de référence des deux branches de mesure (34, 36) peuvent être modifiés sur la base du signal de régulateur.

11. Capteur selon l'une des revendications 1 à 10, **caractérisé en ce que** des asymétries géométriques et électriques entre les canaux de mesure (12, 14) peuvent être compensées par une pondération réglable dans le formateur de différence principal (24).
